(19) Europäisches Patentamt
European Patent Office
Office européen des brevets

(11) EP 0 947 828 B1

(12) EUROPEAN PATENT SPECIFICATION

(45) Date of publication and mention
of the grant of the patent:
25.10.2006 Bulletin 2006/43

(51) Int Cl.:
*G01N 21/88* (2006.01)    *G03F 7/20* (2006.01)

(21) Application number: 99302557.6

(22) Date of filing: 31.03.1999

(54) **Method and apparatus for improved inspection measurements**

Verfahren und Apparat für verbesserte Inspektionsmessungen

Méthode et appareil pour des mesures d'inspection améliorées

(84) Designated Contracting States:
DE FR GB IE

(30) Priority: 31.03.1998 US 52282

(43) Date of publication of application:
06.10.1999 Bulletin 1999/40

(73) Proprietors:
• Infineon Technologies AG
81669 München (DE)
• International Business Machines Corporation
Armonk, NY 10504 (US)

(72) Inventors:
• Gould, Christopher J.
Stanfordville, NY 12581 (US)
• Wheeler, Donald C.
Beacon, NY 12508 (US)

(74) Representative: Litchfield, Laura Marie et al
HASELTINE LAKE
Imperial House
15-19 Kingsway
London WC2B 6UD (GB)

(56) References cited:
EP-A- 0 444 450    EP-A- 0 793 147
WO-A-97/30378    US-A- 4 149 085

**Description**

This disclosure relates to inspection measurements and more particularly to a method and apparatus for making inspection measurements with reduced measurement error during integrated circuit fabrication.

Overlay metrology is used for determining the quality of products, for example, integrated circuits. In particular overlay metrology is used to determine the alignment of critical features which define, for example an integrated circuit device. A misalignment of these features can cause electrical opens or shorts thus destroying product functionality. To ensure integrated circuit (IC) product quality, overlay metrology must be done with high accuracy and precision. Typically, the overlay accuracy and precision is about 3% of minimum pattern or feature size. For example, a 150 nm feature requires an overlay accuracy of $\pm 5$ nm. A major contributor to measurement uncertainty is the dependency on the feature being measured. For increasingly small scale IC devices, accurate measurement of critical features relies heavily on instruments such as precision microscopes and computer algorithms. For an accurate measurement reading from a microscope, a robust and meaningful computer algorithm is necessary.

IC devices (chips) are fabricated on a semiconductor substrate wafers. The wafers are usually round while the IC chips are rectangular in shape and positioned in a grid across the wafer. During processing, it is necessary to monitor and align the grid of one level to that of a subsequent level to ensure proper masking and material deposition. This is required to achieve proper chip functionality.

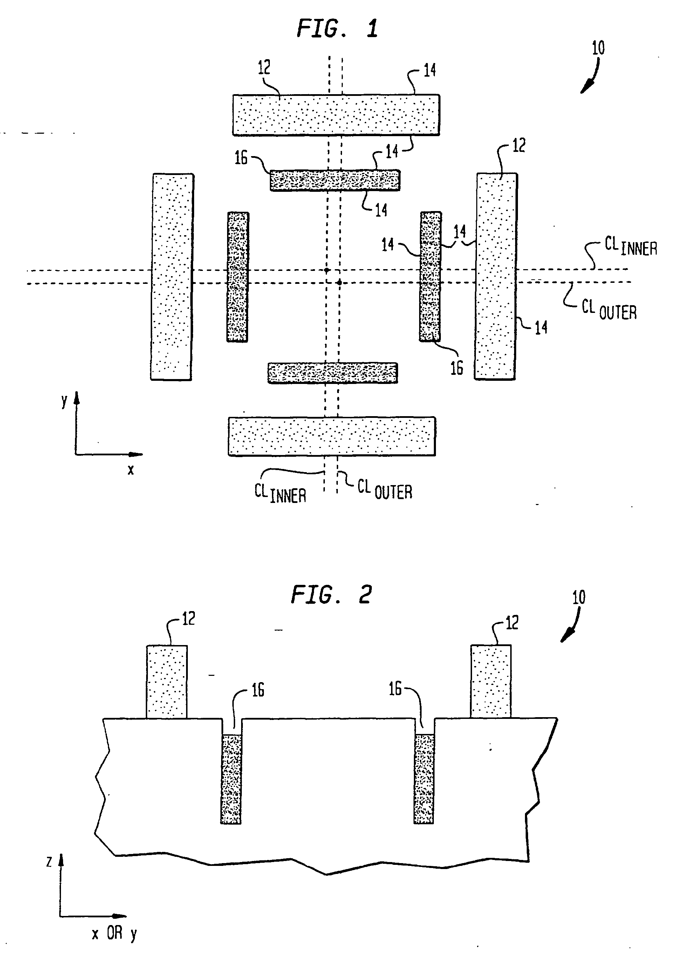

To monitor and maintain level to level alignment, features are built in to the chip pattern which are viewed with a microscope. These are called overlay measurement structures and are comprised of a bullet (on the aligning level) and a target (the level to be aligned to). Referring to FIG. 1, a top view of a standard overlay metrology structure 10 is shown. Structure 10 includes surface features such as trenches or plateaus 16 below the surface and elevated structures 12 above the surface. Each feature has edges 14 which may be used to measure dimensions between the features for inspection purposes. The illustrative example of FIG. 1 shows a structure 12 as a bullet and a trench structure 16 as a target. To further illustrate structure 10, a cross-sectional view is provided in FIG. 2.

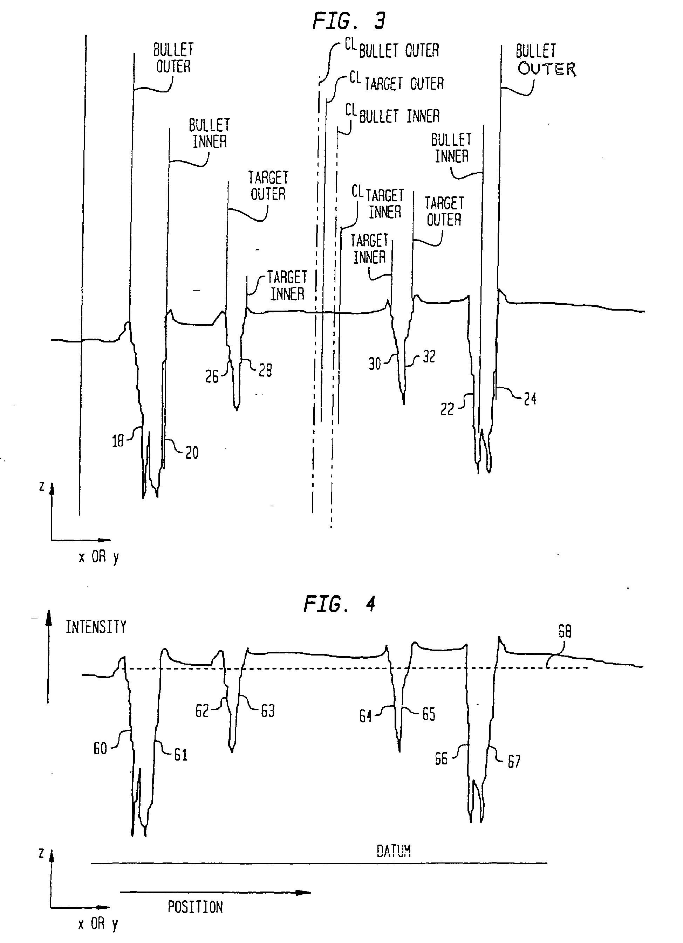

To differentiate between edges 14 and therefore mark centerlines, typically an optical microscope, scanning electron microscope or atomic force microscope is used where reflected light or electrons are recorded by a photosensor or electron sensitive device and an intensity profile of the structure is produced (or in the case of atomic microscopy stylus deflections are used to create the intensity profile). FIG. 3 shows an example of an intensity profile across the bullets and targets in one direction (x or y) across structure 10 (FIGS. 1 and 2). The goal of the measurement in this example is to determine a distance between the centerlines of the bullet and target marks, and hence determine the resultant vector misregistration between the aligning levels (bullet to target).

The intensity profile indicates edges 14 as a change in intensity. For example, sloped curves 18, 20, 22 and 24 indicate edges 14 for structures 12 (bullet), and sloped curves 26, 28, 30 and 32 indicate edges 14 for trench structures 16 (target). Edges are defined mathematically as the points of inflection or the maximum or minimum from a first derivative calculated from the structure intensity profile. A centre distance between edge pairs of the bullet, slope curves 18 and 24, is compared to a centre distance between edge pairs of the target, slope curves 26 and 32, to give a misregistration value in either x or y direction. For these edge pairs, the misregistration may be defined as

$$CL_{bullet\_outer} - CL_{target\_outer}$$

If different edge pairs of the bullet and target are compared, for example, slope curves 20 and 22 relative to 28 and 32, a slightly different misregistration value may result, such that:

$$CL_{bullet\_outer} - CL_{target\_outer} \neq CL_{bullet\_inner} - CL_{target\_inner}$$

The method described above has disadvantages if asymmetric signals are present. If a different edge pair is used to determine the centre lines a different location may result. This occurs due to the intensity profile signal's edge slope variation. The intensity profile is never perfectly symmetrical which means the slopes of the edges will be slightly different between the edges and sets of edge pairs. This error is known as centreline shift and has been observed to be of the order of 10nm $\sigma$.

European Patent Application EP0444450 A1 discloses an example of a known method involving the use of verification marks to try to align the surface of a wafer and a layer of photoresist.

The invention defined in independent method claim 1, seeks to provide a method of reducing measuring uncertainty in inspection systems using intensity profiles. The invention also seeks to provide a method for reducing edge slope variations in intensity profiles to better define centre points and more accurately determine misregistrations for semiconductor wafers.

In a method for reducing measurement error, the step of providing an intensity profile may further include the steps of providing an energy source for irradiating the surface feature and collecting intensity data by measuring the intensity of reflected radiation from the surface feature. The step of providing an intensity profile may further includes the steps of scanning the surface feature to determine intensity differences and collecting intensity data across the surface feature. The step of employing centroid locations and intensity profile areas of two or more surface features to assess a measurement quality may be included. The step of adjusting a focus to provide a better defined intensity profile thereby providing more reduced measurement error may be included. The step of computing the area may further include an iterative numerical integration algorithm.

In alternate methods for reducing measurement uncertainty for reference locations between process steps, the step of providing an intensity profile may further include the steps of providing an energy source for irradiating the features and collecting intensity data by measuring the intensity of reflected radiation from the features. The step of providing an intensity profile may further includes the steps of scanning the surface feature to determine intensity differences and collecting intensity data across the surface feature. The step of employing centroid locations and intensity profile areas of two or more surface features to assess a measurement quality may be included. The method may further include the step of adjusting a focus to provide a better defined intensity profile thereby providing more reduced measurement error. The step of computing the area may further include an iterative numerical integration algorithm. The first and second reference locations may be center lines between each set of features. The first and second reference locations may be points between each set of features. The first set of features may be substantially symmetrical about a first center point, and the second set of features may substantially symmetrical about a second center point, and the method may further include the step of measuring the misregistration between the first and second center points.

The intensity measurement device of the invention defined in claim 10 may include an energy source for irradiating the surface features and collecting intensity data by measuring the intensity of reflected radiation from the surface features. The computing means may include a processor. The surface features may be positioned on a semiconductor wafer. The measuring device may include an optical microscope. The intensity measurement device may include a photosensor. The measuring device may include a scanning electron microscope. The intensity measurement device may include an electron sensor. The measurement device may be an atomic force microscope.

According to one aspect of the present invention there is provided a method for reducing measurement uncertainty for reference locations between process steps, wherein it comprises the steps of: providing an intensity profile for a first set of features of a first process step and for a second set of features of a second process step; computing areas for regions of the intensity profile enclosed by intensity data of the features and a threshold intensity on the intensity profile; determining a centroid location for the regions from or based on the areas calculated in the previous step; comparing centroid locations from the first set of features to determine a first reference location; comparing centroid locations from the second set of features to determine a second reference location; evaluating a difference between the first and second reference locations to determine a misregistration between the first and second set of features.

According to another aspect of the present invention there is provided an apparatus for reducing measurement error comprising: an intensity measurement device operable to measure intensity differences of surface features, and comprising a memory for storing intensity data as a function of position of the surface features to form an intensity profile; wherein it comprises: means operable to compute areas for regions of the intensity profile enclosed by intensity data of the features and a threshold intensity on the intensity profile; means operable to determine a centroid location for the regions from or based on said computed areas for regions of the intensity profile enclosed by intensity data of the features and a threshold intensity on the intensity profile; means operable to compare centroid locations from the first set of features to determine a first reference location; means operable to compare centroid locations from the second set of features to determine a second reference location; means operable to evaluate a difference between the first and second reference locations to determine a misregistration between the first and second set of features.

For a better understanding of the present invention, and to show how it may be brought into effect, reference will now be made, by way of example, to the accompanying drawings, in which:

FIG. 1 is a top view of a structure to be measured;
FIG. 2 is a cross sectional view of the structure of FIG. 1;
FIG. 3 is a plot of an intensity profile produced by detection of reflected light or electrons across the structure of FIG. 1;
FIG. 4 is another plot of an intensity profile of trench structures as shown in FIG. 1 and FIG. 2;
FIG. 5 is a plot of the intensity profile of FIG. 4 showing area calculation boundaries;
FIG. 6 is a plot of the intensity profile of FIG. 4 showing centroid locations;
FIG. 7 is a plot of the intensity profile of FIG. 4 showing a centreline determined using the centroid locations of FIG. 6;
FIG. 8 is a top view of the structure shown in FIG. 1 having center lines and reference points in accordance with the present invention; and

FIG. 9 is a block diagram of a measuring apparatus in accordance with the present invention.

The present invention relates to inspection measurements and more particularly, to a method and apparatus for making inspection measurements with reduced measurement error. A method for reducing measuring uncertainty for inspection systems using intensity profiles includes determining a centroid for a region of the intensity profile. Intensity data recorded by scanning across a wafer surface is recorded and plotted. The region below a threshold intensity is chosen and the area and the centroid for the region are calculated. The centroid for each region is then used to determine mark center lines. Based on the centroid approach the edge slope variations are averaged out and thereby reduced in effect. In the following illustrative example of the present invention reference is made to the drawings based on a Cartesian coordinate system. The coordinate system is defined by x, y and z directions which have been arbitrarily assigned and one skilled in the art understands that these designations may be substituted for one another. -

Referring now in specific detail to the drawings in which like reference numerals-identify similar or identical elements throughout the several views, FIG. 4 is an intensity profile of a scan across resist structures 12 and trench structures 16 of FIGS. 1 and 2. Edge slopes 60 through 67 show variations along each edge slope curve. Edge slope curves indicate a change in intensity due to surface features. The change in intensity is evaluated relative to a baseline or threshold intensity 68.

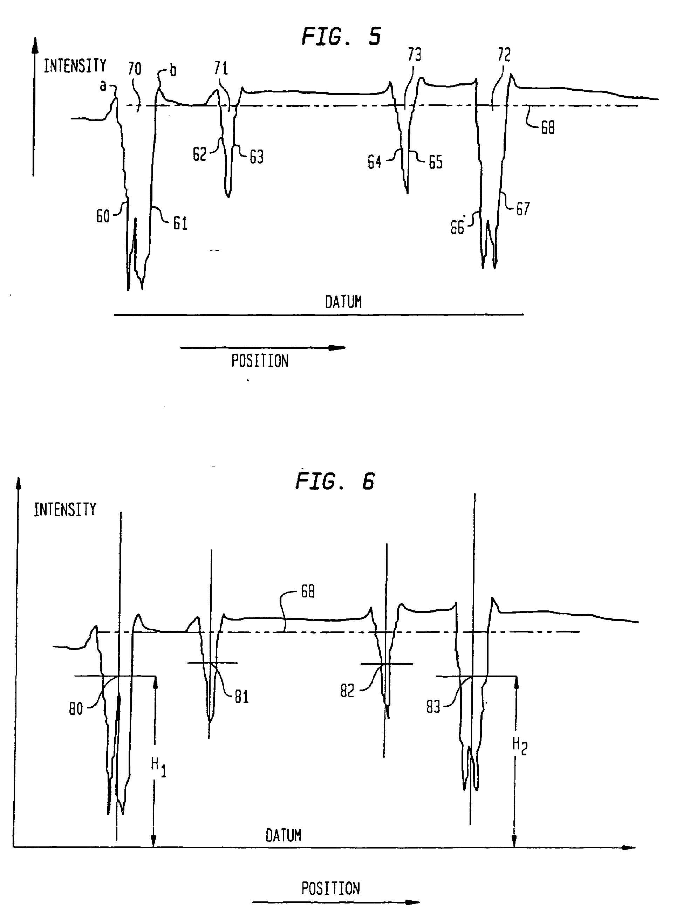

Referring to FIG. 5, regions 70 through 73 are delineated by edge slopes 60 through 67. Regions 70 through 73 are enclosed by extending threshold 68 over each region (dashed line). Since the intensity profile is plotted in x (or y) and z (Cartesian) coordinates, or may be converted thereto, a technique in accordance with the invention is used to calculate an area for regions 70 through 73. In one embodiment, an iterative numerical integration is used, for example, the Newton method, as is known in the art. In other methods, an area may be calculated by a Trapezoid Rule, also known in the art. In a general case, the area A may be calculated as follows:

$$A_{Region} = \int_{-a}^{b} f(x)dx$$

where a and b are limits along a chosen datum and threshold on the profile as illustratively indicated for region 70 in FIG. 5, and f(x) is a function that yields a value of the ordinate (z value in this case) on a boundary of the region of the intensity profile when an abscissa value (x or y value) is provided. The chosen datum is a reference point for the measured intensity, and is preferably about 0. The threshold is also chosen as a set value of the maximum intensity. The threshold, in one embodiment, is chosen to be about 90 % of maximum intensity output from an energy source. Other threshold values, depending on the application, are also useful. Threshold values may be chosen to optimize performance of the invention. For example, the threshold values may be chosen according to user specified settings to define the desired region to integrate over to produce optimal results for specific applications. The intensity profile is developed between the datum and the threshold which may be chosen in accordance with predetermined criteria.

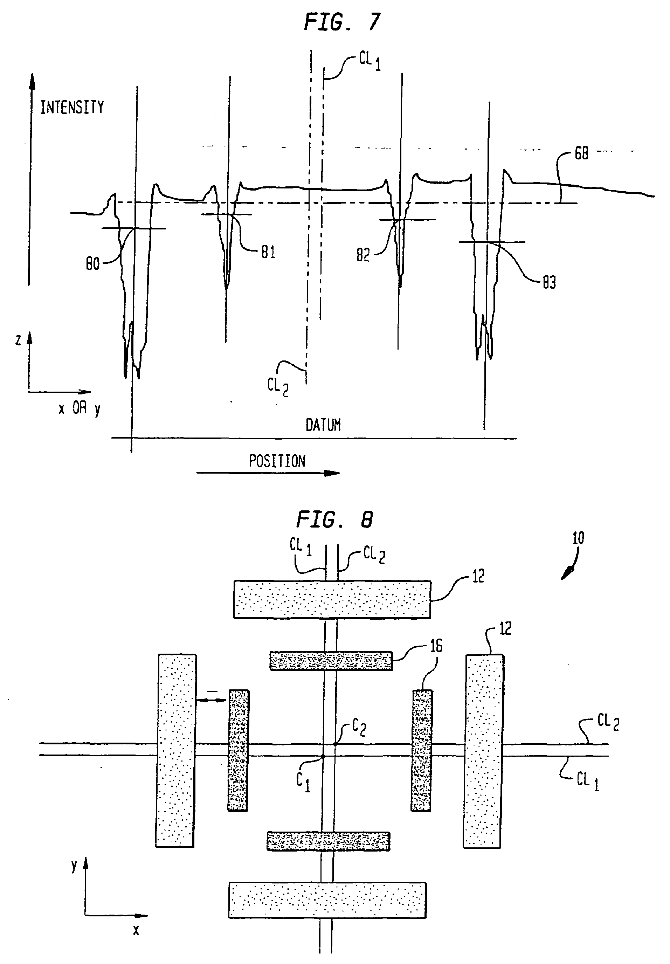

Referring to FIG. 6, the areas for regions 70 through 73 are calculated above and are used to determine the value of a centroid for each region. The centroid for each region is calculated as follows. In Cartesian coordinates, the x (or y) and z components of the centroid, denoted as x' (or y') and z' may be calculated according to the following equations:

$$x' = \frac{1}{A} \int_{R} xdA$$

$$z' = \frac{1}{A} \int_{R} zdA$$

where A is the area of the region R, x and z are the respective coordinates of each differential piece of area dA. The centroid coordinates can be used to determine a centerline shift for each region for measurement diagnostics. Although Cartesian coordinates are shown other coordinate systems are contemplated. The z component of the centroid, z= may also be calculated as above and used to determine the quality of measurement as described below.

Centroids 80 through 83 may be used to represent the location of the features on the intensity profile. In this way the variations in edge slope data are minimized and a better reference location is provided.

Referring to FIG. 7, centroid locations 80 through 83 are compared to determine a first mark center line $CL_1$ based on the centroids of the target (centroid locations 81 and 82 in this example). A second mark center line $CL_2$ may be calculated based on the centroids of the bullet (centroid locations 81 and 82 in this example). $CL_1$ and $CL_2$ may be compared directly or combined with other reference points to determine misregistration between features or feature patterns.

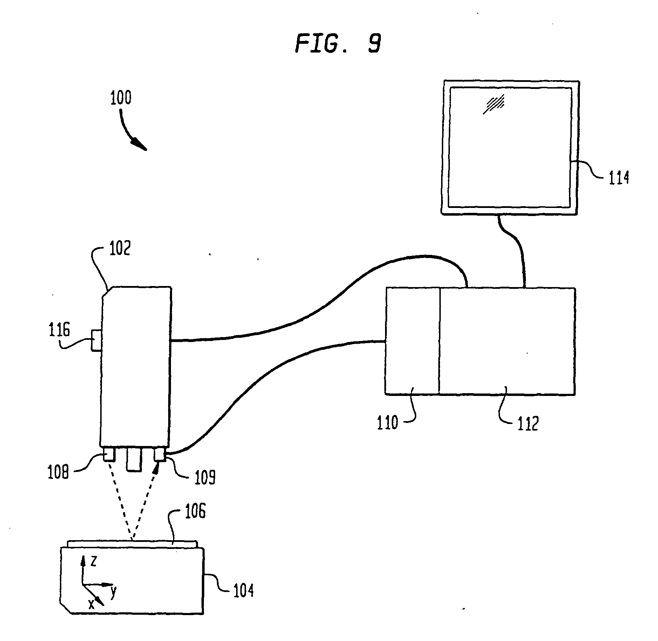

Referring to FIG. 8, the first and second mark center lines, $CL_1$ and $CL_2$, may be produced along another symmetry line to intersect at a first mark center $C_1$, and the second mark center lines $CL_2$ may be produced to intersect at an outer mark center $C_2$. The first and second mark centers, $C_1$ and $C_2$, are then compared to determine the amount of overlay misregistration (bullet relative to the target, i.e $C_2$ to $C_1$). A more accurate mark center location may be provided by using the centroid calculated for each region. In this way, the edge slope variations are avoided. The method of the present invention allows a single center determination to be carried out without being limited to a constant threshold with the ability to select a datum and threshold and calculate centerlines based on mark centroids. Centerline shift errors caused by conventional methods can be reduced to less than 1 nm.

Referring to FIG. 9, a measuring apparatus 100 includes a microscope 102, such as a scanning electron microscope, an optical microscope or an atomic force microscope having a stage 104 for positioning a structure 106 to be measured. An energy source 108 irradiates structure 106. A photosensitive device or electron sensitive device 109 collects reflected intensities and stores the data in a storage device 110. Alternately, deflections of a stylus (not shown) may be used to develop intensity profiles and deflection data stored in storage device 110. A processor 112 is used to perform calculations on the data in accordance with the present invention. A monitor 114 may also be included for real-time viewing of structure 106 during operation.

The centroid of each region may be optimized by tool adjustments to the measuring apparatus. For example, signal comparison may be performed by scanning through focus. More symmetrical signals can be obtained for the intensity profile if, for example, a wafer is placed on stage 104 and moved outside of an isofocal plane as determined by the focus of the microscope 102. In this way, a better focus of surface features may be obtained. This is achieved if stage 104 can scan in the z direction. This method is iterative a first measurement is made. Then an adjustment is made to a focus control 116 (FIG. 9) to change the focus of microscope 102. A second measurement is made and the quality is assessed against the first measurement. If there is an improvement further iterations are performed to further refine the measurement. If there is no improvement further adjustments may be made to improve the quality of the measurement. One criteria for determining the quality of the measurement is to calculate z' as described above. z' is the z component of the centroid and is indicated by H's in FIG. 6. $H_1$ and $H_2$ are determined for two bullets or in the alternative, two targets and are measured relative to the datum. The closer the values of $H_1$ and $H_2$ the better the quality of measurement due to the fact that symmetry is inferred from the areas of the regions and the values of $H_1$ and $H_2$. A registration measurement is taken after the improved measurement has been obtained. In still other preferred methods, the centroid may be adjusted to an optimal position by calculating an optimal centroid location. And adjusted according to the quality determination method described above, i.e. the closer the values of $H_1$ and $H_2$ the better the quality of measurement. Having described illustrative embodiments for reducing measurement error for inspection measurements (which are intended to be illustrative and not limiting), it is noted that modifications and variations can be made by persons skilled in the art in the light of the above teachings. Having thus described the invention with the details, what is claimed and desired protected is set forth in the appended claims.

**Claims**

1. A method for reducing measurement uncertainty for reference locations between process steps, **characterised in that** it comprises the steps of:

   providing an intensity profile for a first set of features (16) of a first process step and for a second set of features (12) of a second process step;
   computing areas for regions (70, 71, 72, 73) of the intensity profile enclosed by intensity data of the features and a threshold intensity (68) on the intensity profile;
   determining a centroid location (80, 81, 82, 83) for the regions (70, 71, 72, 73) from or based on the areas calculated in the previous step;
   comparing centroid locations (81, 82) from the first set of features (16) to determine a first reference location ($CL_1$);
   comparing centroid locations (80, 83) from the second set of features (12) to determine a second reference location ($CL_2$) ;
   evaluating a difference between the first and second reference locations ($CL_1$, $CL_2$) to determine a misregistration between the first and second set of features.

2. The method for reducing measurement uncertainty for reference locations between process steps as claimed in claim 1, wherein the step of providing an intensity profile further comprises the steps of:

   providing an energy source for irradiating the features; and
   collecting intensity data by measuring the intensity of reflected radiation from the features.

3. The method for reducing measurement uncertainty for reference locations between process steps as claimed in claims 1 or 2, wherein the first and second reference locations ($CL_1$, $CL_2$) are centre lines between each set of features.

4. The method for reducing measurement uncertainty for reference locations between process steps as claimed in claims 1 or 2, wherein the first and second reference locations ($CL_1$, $CL_2$) are points between each set of features.

5. The method for reducing measurement uncertainty for reference locations between process steps as claimed in any preceding claim, wherein the first set of features (16) are substantially symmetrical about a first centre point, and the second set of features (12) are substantially symmetrical about a second centre point, and further includes the step of measuring the misregistration between the first and second centre points.

6. The method for reducing measurement uncertainty for reference locations between process steps as claimed in any preceding claim, wherein the step of providing an intensity profile further comprises the steps of:

   scanning the feature to determine intensity differences; and
   collecting intensity data across features.

7. The method for reducing measurement uncertainty for reference locations between process steps as claimed in any preceding claim, further comprising the step of adjusting a focus to provide a better defined intensity profile thereby providing a reduced measurement error.

8. The method for reducing measurement uncertainty for reference locations between process steps as claimed in any preceding claim, wherein the step of computing areas further includes an iterative numerical integration algorithm.

9. The method for reducing measurement uncertainty for reference locations between process steps as claimed in any preceding claim, further comprising the step of employing centroid locations (80, 81, 82, 83) and intensity profile areas of two of more features to assess a measurement quality.

10. An apparatus for reducing measurement error comprising:

    an intensity measurement device operable to measure intensity differences of surface features, and comprising a memory for storing intensity data as a function of position of the surface features to form an intensity profile;

    **characterised in that** it comprises:

    means operable to compute areas for regions of the intensity profile enclosed by intensity data of the features and a threshold intensity on the intensity profile ;
    means operable to determine a centroid location (80, 81, 82, 83) for the regions (70, 71, 72, 73) from or based on said computed areas for regions of the intensity profile enclosed by intensity data of the features and a threshold intensity on the intensity profile;
    means operable to compare centroid locations (81, 82) from the first set of features (16) to determine a first reference location ($CL_1$);
    means operable to compare centroid locations (80, B3) from the second set of features (12) to determine a second reference location ($CL_2$);
    means operable to evaluate a difference between the first and second reference locations ($CL_1$, $CL_2$) to determine a misregistration between the first and second set of features.

11. The apparatus claimed in claim 10, wherein the intensity measurement device includes an energy source operable to irradiate the surface features and collect intensity data by measuring the intensity of reflected radiation from the surface features.

**Patentansprüche**

1. Verfahren zum Verringern von Messungsungewissheit für Referenzstellen zwischen Verfahrensschritten, **dadurch gekennzeichnet, dass** es die folgenden Schritte umfasst:

   Erstellen eines Intensitätsprofils für eine erste Gruppe von Merkmalen (16) eines ersten Verfahrensschrittes und für eine zweite Gruppe von Merkmalen (12) eines zweiten Verfahrensschrittes;
   Berechnen von Bereichen für Regionen (70, 71, 72, 73) des Intensitätsprofils, die durch Intensitätsdaten der Merkmale und eine Schwellenintensität (68) auf dem Intensitätsprofil eingegrenzt sind;
   Bestimmen einer Schwerpunktstelle (80, 81, 82, 83) für die Regionen (70, 71, 72, 73) aus den Bereichen oder anhand der Bereiche, die in dem vorangegangenen Schritt berechnet wurden;
   Vergleichen von Schwerpunktstellen (81, 82) aus der ersten Gruppe von Merkmalen (16) zum Bestimmen einer ersten Referenzstelle ($CL_1$);
   Vergleichen von Schwerpunktstellen (80, 83) aus der zweiten Gruppe von Merkmalen (12) zum Bestimmen einer zweiten Referenzstelle ($CL_2$) ;
   Auswerten eines Unterschieds zwischen der ersten und der zweiten Referenzstelle ($CL_1$, $CL_2$) zum Bestimmen einer Nichtübereinstimmung zwischen der ersten Gruppe von Merkmalen und der zweiten Gruppe von Merkmalen.

2. Verfahren zum Verringern von Messungsungewissheit für Referenzstellen zwischen Verfahrensschritten nach Anspruch 1, wobei der Schritt des Erstellens eines Intensitätsprofils des Weiteren folgende Schritte umfasst:

   Bereitstellen einer Energiequelle zum Bestrahlen der Merkmale; und
   Erfassen von Intensitätsdaten durch Messen der Intensität von reflektierter Strahlung von den Merkmalen.

3. Verfahren zum Verringern von Messungsungewissheit für Referenzstellen zwischen Verfahrensschritten nach Anspruch 1 oder 2, wobei die erste und die zweite Referenzstelle ($CL_1$, $CL_2$) Mittelachsen zwischen jeder Gruppe von Merkmalen sind.

4. Verfahren zum Verringern von Messungsungewissheit für Referenzstellen zwischen Verfahrensschritten nach Anspruch 1 oder 2, wobei die erste und die zweite Referenzstelle ($CL_1$, $CL_2$) Punkte zwischen jeder Gruppe von Merkmalen sind.

5. Verfahren zum Verringern von Messungsungewissheit für Referenzstellen zwischen Verfahrensschritten nach einem der vorangehenden Ansprüche, wobei die erste Gruppe von Merkmalen (16) im Wesentlichen symmetrisch um einen ersten Mittelpunkt herum angeordnet sind und die zweite Gruppe von Merkmalen (12) im Wesentlichen symmetrisch um einen zweiten Mittelpunkt herum angeordnet sind, und das des Weiteren den Schritt des Messens der Nichtübereinstimmung zwischen dem ersten und dem zweiten Punkt enthält.

6. Verfahren zum Verringern von Messungsungewissheit für Referenzstellen zwischen Verfahrensschritten nach einem der vorangehenden Ansprüche, wobei der Schritt des Erstellens eines Intensitätsprofils des Weiteren folgende Schritte umfasst:

   Abtasten des Merkmals, um Intensitätsunterschiede zu ermitteln; und
   Erfassen von Intensitätsdaten von Merkmalen.

7. Verfahren zum Verringern von Messungsungewissheit für Referenzstellen zwischen Verfahrensschritten nach einem der vorangehenden Ansprüche, das des Weiteren den Schritt des Einstellens eines Fokus' umfasst, um ein besser definiertes Intensitätsprofil zu erhalten, wodurch ein kleinerer Messfehler entsteht.

8. Verfahren zum Verringern von Messungsungewissheit für Referenzstellen zwischen Verfahrensschritten nach einem der vorangehenden Ansprüche, wobei der Schritt des Berechnens von Bereichen des Weiteren einen iterativen numerischen Integrationsalgorithmus enthält.

9. Verfahren zum Verringern von Messungsungewissheit für Referenzstellen zwischen Verfahrensschritten nach einem der vorangehenden Ansprüche, das des Weiteren den Schritt des Verwendens von Schwerpunktstellen (80, 81, 82, 83) und von Intensitätsprofilbereichen von zwei oder mehr Merkmalen umfasst, um eine Messungsqualität zu beurteilen.

**10.** Vorrichtung zum Verringern von Messfehlern, umfassend:

ein Intensitätsmessgerät, das dafür geeignet ist, Intensitätsunterschiede von Oberflächenmerkmalen zu messen, und das einen Speicher zum Speichern von Intensitätsdaten als eine Funktion der Position der Oberflächenmerkmale zum Erstellen eines Intensitätsprofils umfasst;

**dadurch gekennzeichnet, dass** es Folgendes umfasst:

ein Mittel, das dafür geeignet ist, Bereiche für Regionen des Intensitätsprofils zu berechnen, die durch Intensitätsdaten der Merkmale und eine Schwellenintensität auf dem Intensitätsprofil eingegrenzt sind;
ein Mittel, das dafür geeignet ist, eine Schwerpunktstelle (80, 81, 82, 83) für die Regionen (70, 71, 72, 73) aus den errechneten Bereichen oder anhand der errechneten Bereiche für Regionen des Intensitätsprofils, die durch Intensitätsdaten der Merkmale und eine Schwellenintensität auf dem Intensitätsprofil eingegrenzt sind, zu bestimmen;
ein Mittel, das dafür geeignet ist, Schwerpunktstellen (81, 82) aus der ersten Gruppe von Merkmalen (16) zu vergleichen, um eine erste Referenzstelle ($CL_1$) zu bestimmen;
ein Mittel, das dafür geeignet ist, Schwerpunktstellen (80, 83) aus der zweiten Gruppe von Merkmalen (12) zu vergleichen, um eine zweite Referenzstelle ($CL_2$) zu bestimmen;
ein Mittel, das dafür geeignet ist, einen Unterschied zwischen der ersten und der zweiten Referenzstelle ($CL_1$, $CL_2$) auszuwerten, um eine Nichtübereinstimmung zwischen der ersten Gruppe von Merkmalen und der zweiten Gruppe von Merkmalen zu bestimmen.

**11.** Vorrichtung nach Anspruch 10, wobei das Intensitätsmessgerät eine Energiequelle enthält, die dafür geeignet ist, die Oberflächenmerkmale zu bestrahlen und Intensitätsdaten durch Messen der Intensität von reflektierter Strahlung von den Oberflächenmerkmalen zu erfassen.

**Revendications**

**1.** Procédé destiné à réduire l'incertitude sur les mesures pour des emplacements de référence entre des étapes de processus, **caractérisé en ce qu'**il comprend les étapes consistant à :

procurer un profil d'intensité pour un premier ensemble de traits (16) d'une première étape de processus et pour un second ensemble de traits (12) d'une seconde étape de processus,
calculer des surfaces pour les régions (70, 71, 72, 73) présentant le profil d'intensité englobé par des données d'intensité des traits et une intensité seuil (68) sur le profil d'intensité,
déterminer un emplacement de centroïdes (80, 81, 82, 83) pour les régions (70, 71, 72, 73) à partir des surfaces calculées dans l'étape précédente, ou sur la base de celles-ci,
comparer les emplacements de centroïdes (81, 82) du premier ensemble de traits (16) pour déterminer un premier emplacement de référence ($CL_1$),
comparer les emplacements de centroïdes (80, 83) du second ensemble de traits (12) pour déterminer un second emplacement de référence ($CL_2$),
évaluer une différence entre les premier et second emplacements de référence ($CL_1$, $CL_2$) pour déterminer un mauvais alignement entre les premier et second ensembles de traits.

**2.** Procédé destiné à réduire l'incertitude sur les mesures pour des emplacements de référence entre des étapes de processus selon la revendication 1, dans lequel l'étape consistant à procurer un profil d'intensité comprend en outre les étapes consistant à :

procurer une source d'énergie pour irradier les traits, et
recueillir les données d'intensité en mesurant l'intensité du rayonnement réfléchi depuis les traits.

**3.** Procédé destiné à réduire l'incertitude sur les mesures pour des emplacements de référence entre des étapes de processus selon la revendication 1 ou 2, dans lequel les premier et second emplacements de référence ($CL_1$, $CL_2$) sont des lignes centrales entre chaque ensemble de traits.

**4.** Procédé destiné à réduire l'incertitude sur les mesures pour des emplacements de référence entre des étapes de processus selon la revendication 1 ou 2, où les premier et second emplacements de référence ($CL_1$, $CL_2$) sont des

points entre chaque ensemble de traits.

5. Procédé destiné à réduire l'incertitude sur les mesures pour des emplacements de référence entre des étapes de processus selon l'une quelconque des revendications précédentes, où les traits du premier ensemble de traits (16) sont sensiblement symétriques par rapport à un premier point central, et les traits du second ensemble de traits (12) sont sensiblement symétriques par rapport à un second point central, et qui comprend en outre l'étape consistant à mesurer le mauvais alignement entre les premier et second points centraux.

6. Procédé destiné à réduire l'incertitude sur les mesures pour des emplacements de référence entre des étapes de processus selon l'une quelconque des revendications précédentes, où l'étape consistant à procurer un profil d'intensité comprend en outre les étapes consistant à :

analyser le trait pour déterminer les différences d'intensité, et
recueillir les données d'intensité sur tous les traits.

7. Procédé destiné à réduire l'incertitude sur les mesures pour des emplacements de référence entre des étapes de processus selon l'une quelconque des revendications précédentes, comprenant en outre l'étape consistant à ajuster un foyer pour procurer un meilleur profil d'intensité défini en procurant ainsi une erreur de mesure réduite.

8. Procédé destiné à réduire l'incertitude sur les mesures pour des emplacements de référence entre des étapes de processus selon l'une quelconque des revendications précédentes, dans lequel l'étape consistant à calculer des surfaces comprend en outre un algorithme à intégration numérique itératif.

9. Procédé destiné à réduire l'incertitude sur les mesures pour des emplacements de référence entre des étapes du processus selon l'une quelconque des revendications précédentes, comprenant en outre l'étape consistant à employer des emplacements de centroïdes (80, 81, 82, 83) et des surfaces de profils d'intensité de deux traits, ou plus, pour évaluer une qualité de mesure.

10. Dispositif de réduction d'erreur de mesure comprenant :

un dispositif de mesure d'intensité pouvant être mis en oeuvre pour mesurer les différences d'intensité de traits de surface, et comprenant une mémoire destinée à mémoriser des données d'intensité en fonction de la position des traits de surface pour former un profil d'intensité,

**caractérisé en ce qu'**il comprend :

un moyen pouvant être mis en oeuvre pour calculer des surfaces pour des régions présentant le profil d'intensité englobé par des données d'intensité des traits et une intensité seuil sur le profil d'intensité,
un moyen pouvant être mis en oeuvre pour déterminer un emplacement de centroïdes (80, 81, 82, 83) pour les régions (70, 71, 72, 73) à partir ou sur la base desdites surfaces calculées pour des régions présentant le profil d'intensité englobé par des données d'intensité des traits et une intensité seuil sur le profil d'intensité,
un moyen pouvant être mis en oeuvre pour comparer les emplacements de centroïdes (81, 82) du premier ensemble de traits (16) pour déterminer un premier emplacement de référence ($CL_1$),
un moyen pouvant être mis en oeuvre pour comparer les emplacements de centroïdes (80, 83) du second ensemble de traits (12) pour déterminer un second emplacement de référence ($CL_2$),
un moyen pouvant être mis en oeuvre pour évaluer une différence entre les premier et second emplacements de référence ($CL_1$, $CL_2$) pour déterminer un mauvais alignement entre les premier et second ensembles de traits.

11. Appareil selon la revendication 10, dans lequel le dispositif de mesure d'intensité comprend une source d'énergie pouvant être mise en oeuvre pour irradier les traits de surface et recueillir les données d'intensité en mesurant l'intensité du rayonnement réfléchi provenant des traits de surface.

## FIG. 1

10

12    14

16    14
14

14    14    12

CL INNER

14

CL OUTER

16    14

y

x

16

CL INNER    CL OUTER

## FIG. 2

10

12    12

16    16

z

x OR y

## FIG. 3

BULLET OUTER

CL BULLET OUTER

CL TARGET OUTER

CL BULLET INNER

BULLET INNER

BULLET INNER

BULLET OUTER

TARGET OUTER

CL TARGET INNER

TARGET INNER

TARGET OUTER

TARGET INNER

TARGET INNER

26  28

30  32

18  20

22  24

z

x OR y

## FIG. 4

INTENSITY

68

60  61

62  63

64  65

66  67

z

DATUM

POSITION

x OR y

## FIG. 5

INTENSITY

a 70 b 71 73 72

60 61 62 63 64 65 66 67 68

DATUM

POSITION

## FIG. 6

INTENSITY

68

80 81 82 83

$H_1$ $H_2$

DATUM

POSITION

## FIG. 7

## FIG. 8

FIG. 9